# EUROPÄISCHE PATENTSCHRIFT

(11) **EP 3 578 020 B1**
(45) Veröffentlichungstag und Bekanntmachung des Hinweises auf die Patenterteilung: **08.03.2023**
(21) Anmeldenummer: 18702916.0
(22) Anmeldetag: 25.01.2018
(51) Int. Cl.: H05K 5/02

(54) **STECKBARER DATENSPEICHER**
PLUGGABLE DATA STORAGE UNIT
MÉMOIRE DE DONNÉES ENFICHABLE

(30) Priorität: 06.02.2017 DE 102017001021
(43) Veröffentlichungstag der Anmeldung: 11.12.2019
(73) Patentinhaber: SEW-EURODRIVE GmbH & Co. KG, 76646 Bruchsal (DE)
(72) Erfinder: SENFT, Christian, D-76228 Karlsruhe-Grünwettersbach (DE); RICHTER, Sebastian, D-69120 Heidelberg (DE); OTT, Jürgen, 76706 Dettenheim (DE); RITSCHEL, Andreas, 76706 Dettenheim (DE)
(86) Internationale Anmeldenummer: PCT/EP2018/025019
(87) Internationale Veröffentlichungsnummer: WO 2018/141483

(56) Entgegenhaltungen:
- EP-A2- 1 477 984
- DE-U1-202005 015 187
- FR-A1- 2 941 807
- GB-A- 2 444 650
- JP-A- 2001 067 763
- KR-U- 20080 004 451
- US-A- 5 947 572
- US-A1- 2005 157 462
- US-A1- 2006 161 936
- US-A1- 2008 009 197
- US-A1- 2011 312 197
- US-B1- 7 364 445
- US-B1- 7 673 357
- US-B1- 7 874 067
- US-B2- 7 904 622
- US-B2- 8 102 662

## Beschreibung

Die Erfindung betrifft einen steckbaren Datenspeicher, der speziell für den Einsatz in industriellen Umgebungen weiterentwickelt wurde.

Steckbarer Datenspeicher sind beispielsweise USB-Sticks und SD-Karten. Diese werden zum komfortablen Austausch und Transportieren von Daten verwendet. Im industriellen Umfeld werden darauf vor allem Identifizierungs- und Konfigurationsdaten von Geräten gespeichert.

Hierbei ist es wichtig, dass der Anwender einerseits auf den Dateninhalt des Datenspeichers schließen kann, ohne diesen über ein Lesegerät, beispielsweise über einen PC, bestimmen zu müssen, und andererseits der Datenspeicher ohne Probleme durch den Anwender gesteckt bzw. gezogen werden kann, auch wenn es dem Anwender nicht möglich sein sollte, seine Hände vor der Bedienung zu reinigen.

Auf dem Markt verfügbare steckbare Datenspeicher weisen in der Regel ein Gehäuse auf, das in der räumlichen Ausdehnung sehr klein ausgeführt ist und/oder eine glatte Oberfläche besitzt. Beide Merkmale führen zu einer erschwerten Handhabung des steckbaren Datenspeichers in einem stark verschmutzen und rauen Umfeld, welches in Industrieanlagen häufig anzutreffen ist.

Aus der WO 2007 / 029 232 A2 ist ein Datenspeicher bekannt.

Aus der US 8 102 662 B2 ist als nächstliegender Stand der Technik ein Datenspeicher mit einem bistabilen Gleitmechanismus bekannt, wobei die Merkmale des Oberbegriffs nach Anspruch 1 offenbart sind.

Aus der US 7 794 246 B2 ist ein elektronischer Datenspeicher, der in vielen Richtungen steckbar ist.

Aus der KR 2008 0004451 U ist ein steckbarer Datenspeicher bekannt.

Der Erfindung liegt daher die Aufgabe zu Grunde, einen steckbaren Datenspeicher für den Einsatz in industriellen Anwendungen weiterzuentwickeln.

Erfindungsgemäß wird die Aufgabe mit einem steckbaren Datenspeicher nach den in Anspruch 1 angegebenen Merkmalen gelöst.

Ein wichtiges Merkmal der Erfindung ist die Erweiterung des Gehäuses des steckbaren Datenspeichers um eine Zug- und Schubvorrichtung. Unter Gehäuse ist hierbei jene Vorrichtung zu verstehen, die das Element, welches die Informationen beinhaltet, vor Umwelteinflüssen, insbesondere während des Verbindens mit und/oder Entfernen von einem Objekt, schützt.

Typischerweise ist das Gehäuse aus Metall oder Kunststoff, vorteilhafterweise in Spritzgusstechnik, ausgeführt. Als Zugvorrichtung ist ein Element an einem Ortsveränderlichen, insbesondere steckbaren, Objekt gemeint, welches das Ziehen des Objektes ermöglicht, indem es eine Angriffsfläche bietet, um eine entsprechende Zugkraft auf das Objekt zu übertragen. Als Schubvorrichtung ist ein Element an einem beweglichen Objekt zu verstehen, welches das Verschieben des Objekts ermöglicht bzw. vereinfacht, indem es eine Schubfläche zur Verfügung stellt, um eine entsprechende Schubkraft auf das Objekt auszuüben.

Vorteilhafterweise ist mit dieser platzsparenden Vorrichtung zur optimalen Kraftübertragung ein äußerst kompakter, steckbarer Datenspeicher realisierbar.

In der vorliegenden Erfindung wird die Aufgabe dadurch gelöst, dass der Datenspeicher um eine Zug- und Schubvorrichtung ergänzt wird, welche eine platzsparende Vorrichtung zur optimalen Kraftübertragung auf das Gehäuse des Datenspeichers darstellt. Zudem erleichtert eine speziell auf der Zug- und Schubvorrichtung angebrachte Beschriftung einem Anwender die Identifizierung des Datenspeicherinhalts auch im gesteckten Zustand. Zusätzliche Erhebungen auf der Oberfläche des Datenspeichers erhöhen zudem die Bedienbarkeit des steckbaren Datenspeichers, insbesondere in einem rauen industriellen Umfeld.

**Erfindungsgemäß** umfasst die Zug- und Schubvorrichtung zwei Abstandselemente und ein Schubflächenelement, wobei die Anordnung aus den beiden Abstandselementen, dem Schubflächenelement und dem Gehäuse eine verwindungssteife Zuglasche bildet. Unter einem Abstandselement ist hierbei ein mechanisches Bauteil zu verstehen, welches dazu dient, einen definierten räumlichen Abstand zwischen zwei Komponenten herzustellen. Mit den Abstandselementen wird dabei die Beabstandung zwischen dem Gehäuse und dem Schubflächenelement realisiert. Unter Schubflächenelement ist ein mechanisches Element gemeint, über welches Schubkräfte auf ein Objekt aufgebracht werden können. Im vorliegenden Fall sind damit insbesondere Schubkräfte gemeint, die über ein oder mehrere menschliche Finger ausgeübt werden. Dazu ist das Schubflächenelement derart ausgestaltet, dass es mindestens in einer räumlichen Ausdehnung mindestens den Durchmesser eines normierten Prüffingers nach DIN EN 60529 zur Verfügung stellt. Dabei weist der normierte Prüffinger, der dem menschlichen Durchschnittsfinger nachempfunden ist, einen Durchmesser von 12 mm auf. Die Kombination aus Gehäuse, Abstandselemente und Schubfläche bilden die verwindungssteife Zuglasche, über die Zugkräfte auf das Datenspeicherelement aufgebracht werden können. Im vorliegenden Fall sind damit insbesondere Zugkräfte zu verstehen, die über ein oder mehrere menschliche Finger ausgeübt werden. Dazu ist die verwindungssteife Zuglasche derart ausgestaltet, dass diese mindestens eine Aussparung bzw. ein Loch aufweist, welches in seiner räumlichen Ausdehnung mindestens dem Durchmesser eines normierten Prüffingers entspricht. Dies führt einerseits zu einer erhöhten Bedienbarkeit des Datenspeichers, andererseits kann diese Aussparung dazu verwendet werden, um ein Verbindungselement, wie beispielsweise eine Kette, ein Seil oder ein Kabelbinder, an dem Gehäuse des Datenspeichers zu befestigen, um den steckbaren Datenspeicher im industriellen Umfeld ortsfest mit einem bestimmten Punkt in einer Anlage verbinden und so vor einem möglichen Verlust schützen zu können.

**Erfindungsgemäß** weist das Schubflächenelement eine Beschriftung auf. Als Beschriftung wird hierbei das Anbringen einer Markierung auf einer Oberfläche eines Objekts verstanden. Die Beschriftung kann sich beispielsweise auf einer Folie befinden, die über Klebung mit dem Schubflächenelement fest verbunden wird, mittels Lasertechnik in das Werkstück eingebrannt oder über ein übliches Druckverfahren mit Tinte aufgetragen wird. Der Inhalt der Beschriftung kann beispielsweise aus einer Folge von Schriftzeichen, aus einem Barcode oder QR-Code bestehen. Der Vorteil hiervon ist, dass der Anwender durch das aus- bzw. ablesen der Beschriftung auch im gesteckten Zustand des Datenspeichers Rückschlüsse auf den Dateninhalt während des Betriebs ziehen kann.

**Erfindungsgemäß** ist das Schubflächenelement als plane Fläche ausgeführt, wobei die plane Fläche orthogonal sowohl zur Zugrichtung als auch zur Schubrichtung angeordnet ist. Der Vorteil hierbei liegt in einer optimalen Kraftübertragung auf den steckbaren Datenspeicher während des Verbindens bzw. Entfernens des Datenspeichers.

Bei einer weiteren vorteilhaften Ausgestaltung sind die beiden Abstandselemente räumlich parallel zueinander angeordnet. Als räumlich parallel zueinander werden hier zwei Abstandselemente verstanden, die an allen Punkten im gleichen Abstand verlaufen. Damit ist erreichbar, dass zum einen Material einsparbar ist; im Vergleich zu einer geschlossenen Bauform mit nur einem einzigen großflächigen Abstandselement; und zum anderen kann die Kraft gleich-verteilt übertragen werden. Unter gleich-verteilter Kraftübertragung ist hierbei gemeint, dass sich eine Zug- und/oder Schubkraft zu jeweils gleichen Anteilen auf die Abstandselemente aufteilt.

**Erfindungsgemäß** weist mindestens der Teil der Oberfläche des Gehäuses, welcher dem Schubflächenelement am räumlich nächsten liegt, eine Struktur auf, wobei diese Struktur als Rillen-förmige und/oder Noppen-förmige Erhebung ausgeführt ist. Dabei wird unter einer Rillen-förmigen Erhebung eine Struktur verstanden, die längliche und schmale Vertiefungen in einer meist glatten Oberfläche aufweist. Mit einer Noppen-förmigen Erhebung ist eine Struktur gemeint, die eine Dom-artige Erhebung oder Vertiefung auf einer Oberfläche aufweist. Der Vorteil hierbei liegt in einer vereinfachten Bedienbarkeit selbst in einem rauen industriellen Umfeld, insbesondere mit stark verschmutzten Fingern.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand einer Abbildung näher erläutert:

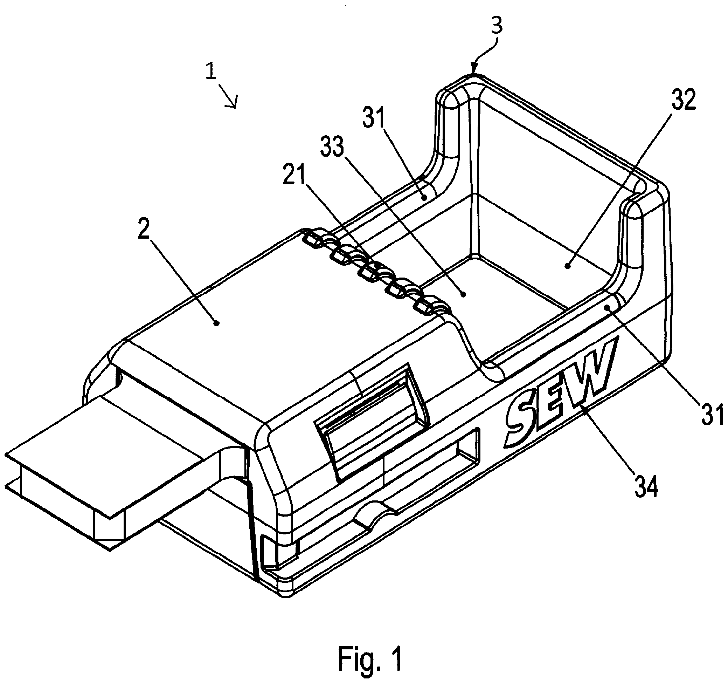

In der Figur 1 ist ein Ausführungsbeispiel eines erfindungsgemäßen steckbaren Datenspeichers mit Zug- und Schubvorrichtung dargestellt.

Der steckbare Datenspeicher umfasst dabei eine Leiterplatte, die typischerweise aus FR4-Material gefertigt ist, die an mindestens einer Stelle als Leiterplattendirektsteckverbinder ausgeführt ist. Unter einem Leiterplattendirektsteckverbinder ist hierbei eine Leiterplatte zu verstehen, die ein oder mehrere Steckkontaktstellen aufweist, die sich im Bereich des Leiterplattenrandes befinden, und über die mit einem weiteren Objekt, welches ein passenden Gegensteckverbindungselement aufweist, eine elektrisch leitende Verbindung zwischen der Leiterplatte des steckbaren Datenspeichers und der Leiterplatte des weiteren Objekts herstellbar ist. Diese Art der Steckverbindung wird insbesondere auch bei PCI-Express eingesetzt. Durch die Verwendung des Leiterplattensteckverbinders ist ein zusätzliches Steckverbindungselement als Bestandteil des steckbaren Datenspeichers einsparbar. Vorteilhafterweise ist damit eine kostengünstige elektrisch leitende und trotzdem kompakte Steckverbindung zwischen dem steckbaren Datenspeicher und dem weiteren Objekt realisierbar.

Idealerweise sind die Steckkontaktstellen zur Herstellung einer elektrisch leitenden Verbindung mit dem Gegensteckkontaktstellen umfassenden Gegensteckverbindungselement vergoldet und überdies redundant ausgeführt. Mit redundant ist damit gemeint, dass mindestens zwei Steckkontaktstellen elektrisch leitend miteinander verbunden zu einem Signal zusammengefasst werden. Durch diese Maßnahmen der Oberflächenveredelung und Parallelisierung der Steckkontaktstellen wird einerseits der Übergangswiderstand deutlich verringert und andererseits die Verfügbarkeit der elektrisch leitenden Verbindung erhöht.

Das erfindungsgemäße Ausführungsbeispiel besitzt zudem eine Leiterplatte, die nur einseitig bestückt ist. Bei der Montage wird die Leiterplatte derart in das Gehäuse eingebracht, dass die nicht bestückte Seite der Leiterplatte auf einer Seite der Gehäuseinnenseite direkt aufliegt, während die andere Seite der Gehäuseinnenseite speziell mit einer Aussparung bzw. einem Hohlraum versehen ist, um darin die sich auf der Leiterplatte befindlichen elektronischen Bauteile wie insbesondere das elektronische Datenspeicherelement aufzunehmen. Der Vorteil hierbei ist, dass eine falsche Orientierung der Leiterplatte beim Herstellen des steckbaren Datenspeichers vermieden werden kann.

Um eine Leiterplatte aufnehmen zu können besteht das Gehäuse des Datenspeichers ein erstes Gehäuseteil und ein weiteres Gehäuseteil, die miteinander mechanisch einrastbar verbindbar sind und wobei zwischen dem ersten Gehäuseteil und dem weiteren Gehäuseteil die Leiterplatte zumindest teilweise angeordnet ist. Das Gehäuse weist dabei ein zusätzliches konstruktives Mittel auf, um die Leiterplatte zu fixieren und diese vor einer Lageänderung relativ zum umgebenden Gehäuse zu schützen.

Ferner weist das Gehäuse eine Kodierung auf, sodass der steckbare Datenspeicher in genau einer räumlichen Orientierung überhaupt in das weitere Objekt gesteckt werden kann. Die wird durch eine Abflachung von zwei Längskanten des Gehäuses erreicht. Denkbar ist auch eine Art Kodier-Stift, der aus dem Gehäuse herausragt bzw. eine Vertiefung im Gehäuse, die einen Kodier-Stift aufnehmen kann. Dadurch wird sichergestellt, dass nur ein bestimmter steckbarer Datenspeicher mit dem weiteren Objekt verbunden werden kann und somit eine Fehlverbindung, die unter Anderem zu einer Zerstörung oder Beschädigung des weiteren Objekts und/oder des steckbaren Datenspeichers führen könnte, vermieden werden kann.

Das Gehäuse weist überdies mindestens eine Führungsschiene auf, die den steckbaren Datenspeicher dabei unterstützt, dass der Datenspeicher in nur einer räumlichen Ausrichtung geführt in das weitere Objekt zu stecken. Dadurch werden Scherkräfte verringert, die sonst den Leiterplattendirektsteckverbinder beschädigen bzw. übermäßig verschleißen können.

Zudem weist das Gehäuse einen reversiblen Einrastmechanismus auf, um den steckbaren Datenspeicher gegen unbeabsichtigtes Entfernen von dem weiteren Objekt, beispielsweise bedingt durch sehr starke Vibrationen in einer Anlage, zu schützen.

Der erfindungsgemäße steckbare Datenspeicher ist zudem ausgestattet mit einem Zug- und Schubelement, welches aus zwei Abstandselementen und einem Schubflächenelement besteht. Dabei bildet das Gehäuse zusammen mit den beiden Abstandselementen und dem Schubflächenelement eine verwindungssteife Zuglasche. Die Abstandselemente sind vorteilhafterweise derart verstärkt ausgestaltet, dass die auf das Schubflächenelement aufgebrachte Schubkraft optimal auf die Abstandselemente aufgebracht werden kann. Idealerweise sind die Abstandselemente hierfür L-förmig gestaltet, um ein Abbrechen der Schubfläche von den Abstandselementen zu vermeiden. Eine in der seitlichen Ansicht erkennbare teilweise Reduzierung der Höhe der Abstandselemente gegenüber dem übrigen Gehäuse und dem Schubflächenelement führt zudem zum verringerten Materialverbrauch und einer verbesserte Handhabung des Datenspeichers.

Das Schubflächenelement selbst weist am Rand eine Erhöhung auf, damit ein bedruckbares Etikett so befestigt werden kann, dass es nicht ohne weiteres von der Seite wieder abgezogen werden kann.

Das Gehäuse weist an der dem Schubflächenelement zugewandten Seite Rillen-förmige Erhebungen auf der Gehäuseoberfläche auf. Diese Erhebungen verbessern die Handhabung speziell im rauen industriellen Umfeld.

Durch das Zusammenspiel der Rillen-förmigen Erhebungen an der Oberfläche des Gehäuses, der L-förmig ausgeführten Form der beiden Abstandselemente und der verwindungssteifen Zuglasche, die insbesondere eine Aussparung im Gehäuse bildet lässt sich der steckbare Datenspeicher auch mit verschmutzen Fingern im industriellen Umfeld gut greifen. Die Rillen verhindern dabei ein Verdrehen des Datenspeichers typischerweise zwischen Daumen und Zeigefinger. Damit lässt sich der Datenspeicher präzise in ein Objekt einführen. Durch die vergrößerte plane Gehäusefläche (Schubflächenelement) lässt sich die benötigte Kraft zum Überwinden der in den Metallfedern eines Gegensteckverbinders entgegengebrachte Kraft genau dosieren. Auch die Handhabung beim Entfernen des steckbaren Datenspeichers von dem Objekt wird durch die in der seitlichen Ansicht zunächst reduzierte Höhe der beiden Abstandselemente begünstigt. Somit ist einer zuverlässige mechanische, wie auch elektronische Verbindung zwischen dem steckbarem Datenspeicher und einem weiteren Objekt realisierbar, die jederzeit den sicheren Austausch des steckbaren Datenspeichers garantiert.

Die Erfindung bezieht sich auf die Weiterentwicklung eines steckbaren Datenspeichers für industrielle Anwendungen. Erfindungsgemäß wird diese Aufgabe dadurch gelöst, dass der Datenspeicher um eine Zug- und Schubvorrichtung ergänzt wird, welche eine platzsparende Vorrichtung zur optimalen Kraftübertragung auf das Gehäuse des Datenspeichers darstellt. Zudem erleichtert eine speziell auf der Zug- und Schubvorrichtung angebrachte Beschriftung einem Anwender die Identifizierung des Datenspeicherinhalts auch im gesteckten Zustand. Zusätzliche Erhebungen auf der Oberfläche des Datenspeichers erhöhen zudem die Bedienbarkeit des steckbaren Datenspeichers, insbesondere in einem rauen industriellen Umfeld.

Die folgende Bezugszeichenliste wird in die Beschreibung einbezogen und erläutert weitere Merkmale der Erfindung.

### Bezugszeichenliste

- 1: Datenspeicher, steckbar
- 2: Gehäuse
- 21: Teil der Oberfläche des Gehäuses
- 22: Struktur der Oberfläche
- 3: Zug- und Schubvorrichtung
- 31: Abstandselement
- 32: Schubflächenelement
- 33: Zuglasche, verwindungssteif
- 34: Beschriftung

## Patentansprüche

1. Steckbarer Datenspeicher (1), aufweisend
**ein Gehäuse (2) und einen elektrischen Verbinder, mit welchem eine elektrische Verbindung mit einem anderen Objekt herstellbar ist,**
**wobei** das Gehäuse (2) eine Zug- und Schubvorrichtung (3) umfasst,
**wobei die Zug- und Schubvorrichtung (3) zwei Abstandselemente (31) und ein Schubflächenelement (32) umfasst,**
**wobei die Anordnung aus den beiden Abstandselementen (31), dem Schubflächenelement (32) und dem Gehäuse (2) eine insbesondere verwindungssteife Zuglasche (33) bildet,**
**wobei das Schubflächenelement (32) als plane Fläche ausgeführt ist,**
**wobei die plane Fläche orthogonal sowohl zur Zugrichtung als auch zur Schubrichtung angeordnet ist,**
**wobei mindestens der Teil der Oberfläche des Gehäuses (2), welcher dem Schubflächenelement (32) am räumlich nächsten liegt, eine Struktur (21) aufweist,**
**wobei diese Struktur (21) als Rillen-förmige und/oder Noppen-förmige Erhebung ausgeführt ist,**
**dadurch gekennzeichnet, dass**
**das Schubflächenelement (32) eine Beschriftung (34) aufweist,**
**wobei die Abstandselemente (31) L-förmig gestaltet sind,**
**insbesondere indem eine in der seitlichen Ansicht erkennbare teilweise Reduzierung der Höhe der Abstandselemente (31) gegenüber dem übrigen Gehäuse (2) und dem Schubflächenelement (32) ausgeführt ist.**

2. Steckbarer Datenspeicher nach Anspruch 1,
**dadurch gekennzeichnet, dass**
die beiden Abstandselemente (31) räumlich parallel zueinander angeordnet sind.

## Claims

1. Pluggable data store (1) having
a housing (2) and an electrical connector, by which an electrical connection to another object can be established,
wherein the housing (2) comprises a push-pull device (3),
wherein the push-pull device (3) comprises two spacer elements (31) and a pushing-surface element (32),
wherein the assembly of the two spacer elements (31), the pushing-surface element (32) and the housing (2) forms an in particular torsionally rigid pulling lug (33),
wherein the pushing-surface element (32) is configured as a planar surface,
wherein the planar surface is arranged orthogonally to both the direction of pull and the direction of push,
wherein at least the part of the surface of the housing (2) that is spatially closest to the pushing-surface element (32) has a structure (21),
wherein said structure (21) is configured as a groove-shaped and/or stud-shaped projection, **characterised in that**
the pushing-surface element (32) has an inscription (34),
wherein the spacer elements (31) are formed in an L shape,
in particular by reducing the height of the spacer elements (31) in parts, in a manner visible in a side view, compared with the rest of the housing (2) and the pushing-surface element (32).

2. Pluggable data store according to claim 1,
**characterised in that**
the two spacer elements (31) are arranged so as to be spatially parallel to one another.

## Revendications

1. Mémoire de données (1) enfichable, comportant
un boîtier (2) et un connecteur électrique au moyen duquel une jonction électrique peut être instaurée avec un objet autre,
ledit boîtier (2) incluant un dispositif (3) de traction et de poussée,
lequel dispositif (3) de traction et de poussée comprend deux éléments d'espacement (31) et un élément (32) formant surface de poussée,
sachant que l'ensemble constitué des deux éléments d'espacement (31), de l'élément (32) formant surface de poussée, et du boîtier (2), matérialise une tirette (33) notamment résistante au gauchissement,
ledit élément (32) formant surface de poussée étant réalisé en tant que surface plane, laquelle surface plane est disposée orthogonalement, tant vis-à-vis de la direction de traction que vis-à-vis de la direction de poussée,
sachant qu'au moins la partie de la surface du boîtier (2), spatialement la plus rapprochée de l'élément (32) formant surface de poussée, est munie d'une structure (21),
laquelle structure (21) est réalisée en tant que protubérance revêtant la forme de striures et/ou de nodosités,
**caractérisée par le fait que**
l'élément (32) formant surface de poussée comporte une inscription (34),
les éléments d'espacement (31) étant configurés en L,
notamment en ce sens qu'une diminution partielle de la hauteur desdits éléments d'espacement (31), perceptible en élévation latérale, est concrétisée par rapport au reste du boîtier (2) et à l'élément (32) formant surface de poussée.

2. Mémoire de données enfichable selon la revendication 1,
**caractérisée par le fait que**
les deux éléments d'espacement (31) occupent des emplacements spatiaux mutuellement parallèles.
